# EUROPEAN PATENT APPLICATION

(11) **EP 0 731 512 A2**
(43) Date of publication of application: **11.09.1996**
(21) Application number: 96300829.7
(22) Date of filing: 07.02.1996
(51) Int. Cl.: H01L 33/00

(54) **Light emitting diode**

(30) Priority: 10.03.1995 US 401543
(71) Applicant: Hewlett-Packard Company, Palo Alto, California 94304 (US)
(72) Inventor: Kuo, Chihping, Milpitas, California 95035 (US)
(74) Representative: Jehan, Robert

(57) **Abstract**

A light emitting diode (10) having an efficient blue or green light emission is obtained by growing a buffer layer (12) composed of an indium gallium nitride compound-semiconductor buffer on a sapphire substrate (14). A layer of gallium aluminum indium nitride compound-semiconductor (16A), which serves as the light emitting layer or active layer, is formed over the buffer layer (12). The light emitting layer (16A) has a similar indium content as the buffer layer (12) to match more closely the lattice constants of the layers. The lattice defects between the buffer layer (12) and the light emitting layer (16A) are decreased because the addition of indium improves the crystalline quality of the layers. The blue or green light emitting property is further improved due to the enhanced crystalline quality of the light emitting layer (16A).

## Description

This invention relates to a light emitting diode, for example an aluminum gallium indium nitride compound-semiconductor device used in the structure of lasers and light-emitting devices.

Gallium nitride (GaN) compounds have wavelength emissions in the green and blue range of visible light. Because single crystals of gallium nitride are difficult to grow, commercial GaN substrates are unavailable for the epitaxial growth of GaN-based devices. Currently, most GaN-based light emitting devices (LEDs) are epitaxially grown on a sapphire substrate. The difference in lattice constants between the sapphire substrate and the GaN-based semiconductors makes it difficult to grow a high quality GaN-based epitaxial layer on the sapphire substrate. Furthermore, a highly conductive p-type GaN semiconductor is nearly impossible to obtain due to combinations of high n-type background concentration and low p-type doping activity. Although the basic heterojunction device concepts have been well understood for many years, these difficulties stymied the development of efficient heterojunction lasers and LEDs emitting green or blue light using an AlGaInN material system.

During the late 1980s, a highly efficient GaN-based LED became a possibility when researchers discovered the importance of growing GaN or AlN buffer layers at low temperatures. Growing a buffer layer on a sapphire substrate at low temperatures improves the morphology of the subsequently grown GaN layer and reduces the n-type background concentration of the GaN materials. This coupled with post-growth thermal annealing or low energy electron beam irradiation to activate the p-type dopants has made growing conductive p-type GaN easier. These technological advances have greatly accelerated the progress in device development of an AlGaInN material system for optoelectronics and other applications.

Figure 1 illustrates a prior art semiconductor (as taught by Manabe, et al. in U.S.P.N. 5,122,845) having a AlN buffer layer to improve the GaN material quality for an efficient blue LED. Figure 2 illustrates another prior art semiconductor (as taught by Nakamura in U.S.P.N. 5,290,393) having an AlₓGa₁₋ₓN(0≤x<1) for the same purpose but directed towards an efficient green LED. However, both methods exhibit similar problems. One major problem is the purity of the color of these LEDs. In both cases of the prior art, the LED produces a whitish color to the human eye that is composed of wide spectrum ultraviolet and visible wavelengths. Further, eye damage can result from prolonged exposure to the intense UV light. These LEDs are therefore inappropriate for many applications because the color is unpure and also unsafe. A second problem with the prior art is that the material selected for the buffer layers limits the indium content to less than 25% and the thickness of Ga₁₋ₓInₓN active layer to less than 2000Å. This is to avoid the generation of misfit dislocations in the heterojunction interface so that the efficiency of the device can be maintained. Misfit dislocations are detrimental to the performance of the photonic devices, such as laser and LEDs. As a result, the device is limited to a thin strained Ga₁₋ ₓInₓN active layer which limits the band-to-band recombination process because the tunable range of the bandgap energy of the active layer is proportional to the indium content. The resulting emissions from the donor-acceptor pair recombination process of these LEDs are not in the color range of the visible spectrum. The spectrum width of recombination of the donor-acceptor pairs when used for generating blue and green light is very broad and inefficient when compared to band-to-band recombination.

A safe and efficient LED emitting light in the visible range without limiting the thickness or indium content of the Al_{y}Ga_{1-x-y}InₓN double heterostructure layer is desirable. It would also be beneficial if the double heterostructure of the active layer could be more efficiently used to provide practical commercial light emitting applications.

The present invention seeks to provide an improved light emitting diode.

According to an aspect of the present invention, there is provided a light emitting diode as specified in claim 1.

In the preferred embodiment, a light emitting diode (LED) in which a blue light is a high-efficiency emitting light can be obtained by growing an Al_{y}Ga_{1-x-y}InₓN based compound-semiconductor buffer layer on a sapphire substrate. An active layer composed of double heterostructure (DH) of Al_{y}Ga_{1-x-y}InₓN is formed over a low temperature grown Ga₁₋ₓInₓN buffer layer. Because the DH structure and the buffer layer havesimilar indium contents, the DH structure has a similar lattice constant to that of the buffer layer. An optional dislocation reduction layer, which may be a superlattice structure either containing strained or unstrained layers of Al_{y}Ga_{1-x-y}InₓN alloys or a linear graded layer of Al_{y}Ga_{1-x-y}InₓN alloy can be included between the buffer layer and the DH structure to prevent the dislocations in the buffer layer from propagating into the active layer of the DH structure.

As a result, the efficiency of the Al_{y}Ga_{1-x-y}InₓN DH structure LED for visible light applications can be further improved due to the addition of indium in the alloys which eliminates the using the donor-acceptor pair recombination process and this strained active layers. The color purity of the blue and green Al_{y}Ga_{1-x-y}InₓN based LEDs is also improved.

The method also envisages a method of producing a light emitting diode as herein specified, which includes steps apparent from the teachings herein.

An embodiment of the present invention is described below, by way of example only, with reference to the accompanying drawings, in which:

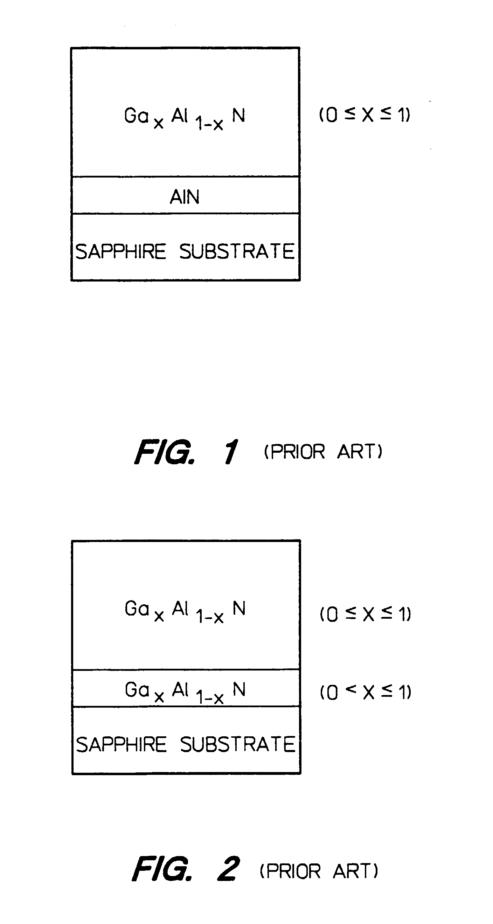

Figure 1 illustrates a prior art semiconductor structure.
Figure 2 illustrates another prior art semiconductor structure.
Figure 3 is a cross-sectional view of an embodiment of the semiconductor structure.
Figure 4 is a cross-sectional view of another embodiment of the semiconductor structure.

It will be appreciated by the reader skilled in this art that any values or ranges given herein can be modified or adjusted by common extents without losing the effects sought. Ranges given herein are also intended to be inclusive of the end values.

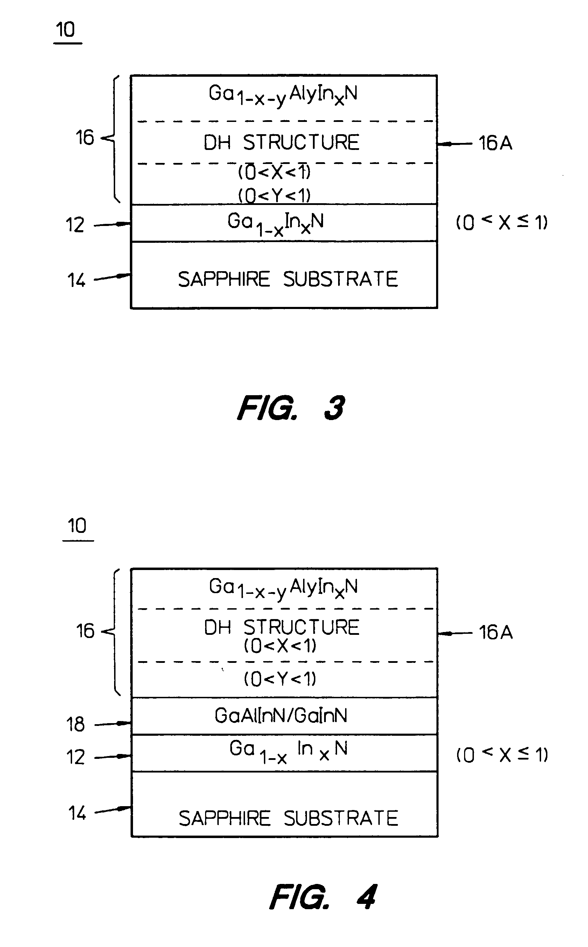

Figure 3 is a cross-sectional view of an embodiment of the semiconductor structure 10. A buffer layer 12 composed of an gallium indium nitride compound-semiconductor buffer layer is formed on a sapphire substrate 14. A DH structure layer 16 containing an active layer 16A of gallium aluminum indium nitride compound-semiconductor is formed over the buffer layer 12.

The buffer layer 12 comprising Ga₁₋ₓInₓN (0<x≤1) is formed directly on the sapphire substrate 14 at a growth temperature that ranges from 400C to 950C, while the thickness of the buffer layer 12 may vary between 50Å and 500Å. The growth temperature varies in direct proportion with the indium content of the buffer layer 12, such that the higher the indium content, the lower the growth temperature. The DH structure layer 16 comprising Al_{y}Ga_{1-x-y}InₓN (0<x<1; 0<y<1) is formed over the buffer layer 12 at a growth temperature that ranges from 700C to 1050C.

Introducing indium into the buffer layer 12 allows for increased indium content in the DH structure layer 16. Preferably, the difference between the indium content of the buffer layer 12 and that of the active layer 16A should be within 20%. As a result, the lattice constant of the DH structure layer 16 more closely matches the lattice constant of the buffer layer 12. Better lattice constant matching is obtained when the indium content of the active layer 16A is equal to the indium content of the buffer layer 12. Reducing the difference between the lattice constant of the buffer layer 12 and the lattice constant of the DH structure layer 16, preferably within a tolerance of ± .5%, improves the crystalline quality of the DH structure layer 16. Indium further narrows the spectral width of the devices because the emissions from the active layer 16A will mainly be band-to-band transitions. This results in a pure and more desirable light emission for many LED applications.

Figure 4 is a cross-sectional view of another embodiment of the semiconductor structure 10. A dislocation reduction layer 18, containing a gallium aluminum indium nitride compound and a gallium indium nitride compound, is positioned between the buffer layer 12 and the DH structure layer 16. The dislocation reduction layer 18 absorbs the difference between the lattice constant of the buffer layer 12 and that of the DH structure 16.

The dislocation reduction layer 18 is formed at a growth temperature that ranges from 400C to 950C, similar to the buffer layer 12. Structurally, the dislocation reduction layer 18 may be a strained super lattice structure or a linear graded structure composed of an aluminum gallium indium nitride compound.

The disclosures in United States patent application no. 08/401,543, from which this application claims priority, and in the abstract accompanying this application are incorporated herein by reference.

## Claims

1. A light emitting diode including:
a sapphire substrate (14);
a buffer layer (12) including a first lattice constant and a first indium content, formed on the sapphire substrate (14), composed of an indium gallium nitride compound; and
a top layer (16) including a second lattice constant and a second indium content, positioned over the buffer layer (12), composed of a gallium indium aluminum nitride compound;
wherein the difference between the first and the second lattice constant is within 5E-3.

2. A light emitting diode as in claim 1, wherein the buffer layer (12) has a thickness between 5µm and 50µm, inclusively.

3. A light emitting diode as in claim 1 or 2, wherein the buffer layer (12) is grown at a temperature between 400°C and 950°C.

4. A light emitting diode as in claim 1, 2 or 3, comprising a dislocation reduction layer (18) positioned between the buffer layer (12) and the top layer (16), wherein the dislocation reduction layer (18) is operable to absorb the difference between the first and the second lattice constants.

5. A light emitting diode as in claim 4, wherein the dislocation reduction layer (18) is a strained super lattice structure.

6. A light emitting diode as in claim 4, wherein the dislocation reduction layer (18) is a linear graded structure composed of an aluminum gallium indium nitride compound.

7. A light emitting diode as in any preceding claim, wherein the difference between the first and the second indium contents is within 20%.
